# EUROPEAN PATENT SPECIFICATION

(11) **EP 1 811 582 B1**
(45) Date of publication and mention of the grant of the patent: **10.12.2008**
(21) Application number: 06250325.5
(22) Date of filing: 20.01.2006
(51) Int. Cl.: H01L 41/083, H01L 41/047, H01L 41/22

(54) **Piezoelectric actuator**
Piezoelektrischer Aktor
Actionneur piézoélectrique

(43) Date of publication of application: 25.07.2007
(73) Proprietor: Delphi Technologies, Inc., Troy, MI 48007 (US)
(72) Inventor: Cooke, Michael, Gillingham, Kent ME7 1DR (GB)
(74) Representative: Gregory, John David Charles

(56) References cited:
- EP-A- 1 780 813
- DE-A1- 10 237 588
- DE-A1- 10 260 854
- DE-A1-0102004 018 10

## Description

### Technical Field

The invention relates to a piezoelectric actuator comprising a stack of laminated piezoelectric layers interdigitated with internal electrode layers. In particular, although not exclusively, the invention relates to the configuration of the internal electrode layers in order to reduce the occurrence of cracking within the stack.

### Background to the Invention

In the field of automotive fuel injection systems, it is known to provide a fuel injector with a piezoelectric actuator as a means for controlling the injection of fuel into associated combustion cylinders of the engine.

European patent EP0995901, for example, describes an automotive fuel injector having a piezoelectric actuator arranged to control movement of an injector valve needle towards and away from a valve seating, thus controlling whether or not fuel is injected through a set of nozzle outlets. The piezoelectric actuator includes a stack of piezoelectric layers that are interleaved with internal electrodes layers. The length of the stack, and thus the position of the injector valve needle, is controlled by varying the voltage that is applied to the internal electrode layers.

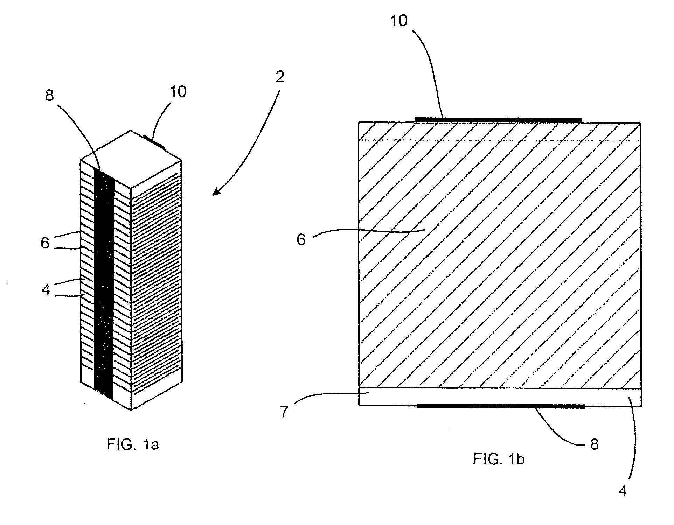

Figure 1a shows a typical stack-type piezoelectric actuator 2. Each piezoelectric layer 4 and each internal electrode layer 6 of the actuator 2 (only two of which are labelled in Figure 1) are of the form of rectangular tiles which provides the actuator 2 with a rectangular cross-section. Each internal electrode layer 6 covers the surface of an adjacent piezoelectric layer 4 save for an uncovered insulating region 7 along one edge of the piezoelectric layer, as shown in Figure 1b, which remains uncovered. The position of the insulating region 7 alternates between successive layers 6 such that it is on one side of the actuator 2 on alternative ones of the layers 6 and on the opposite side of the actuator 2 for the layers 6 in between. Alternate internal electrode layers 6 therefore form a first group for connection to positive external electrode 8 (shown attached to the front face of the actuator 2 in Figure 1) and the remaining layers 6 form a second group for connection to a negative external electrode 10 (shown on the rear face of the actuator 2 in Figure 1).

One problem with this arrangement is that the rectangular profile of the stack can result in an actuator which is inefficient in its utilisation of space when it is installed within a fluid chamber of an injector. Another problem is that the relatively sharp corners of the actuator 2 adhere poorly to insulating coatings that may be applied to it for the purpose of protection against chemically aggressive operational environments.

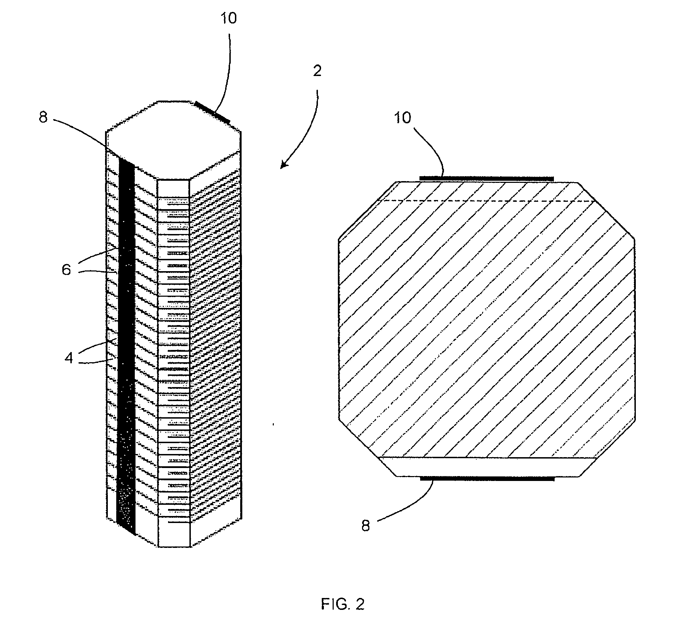

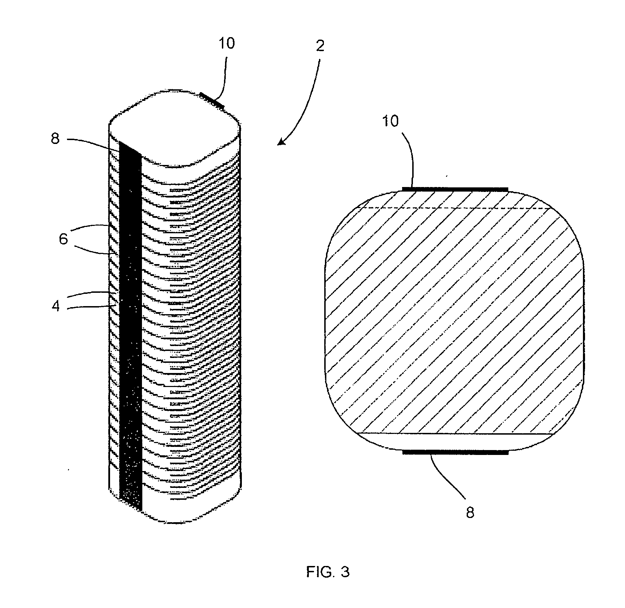

To address the above problems, it is known to apply chamfers or radii to the corners of the actuator 2, as shown in Figures 2 and 3. However, it has been observed that applying such radii or chamfers causes stress concentrations, in use, which increase the likelihood of crack formation leading to reduced actuator service life. It is therefore an object of the invention to provide an improved piezoelectric actuator which is less susceptible to cracking.

For further information regarding conventional piezoelectric actuators, the reader is directed to DE-A1-10237588 and DE-A1-10-2004-018100.

### Summary of Invention

It is against the above background that the invention provides a piezoelectric actuator comprising:
a stack of piezoelectric elements defining an external actuator boundary of substantially rectangular form and having first and second sides with rounded or chamfered corners, and
a plurality of internal electrode elements arranged to form a positive polarity group of electrode elements and a negative polarity group of electrode elements, wherein each of the internal electrode elements of one polarity is provided with an insulating region arranged adjacent to an associated one of the first and second sides of the external actuator boundary,
wherein the insulating region is provided by a recess defining an internal electrode edge which is substantially parallel to said associated one of the sides of the external actuator boundary and its corners, such that the insulating region has a substantially uniform width along said associated one of the sides of the external actuator boundary, and
**characterised in that** the recess further defines opposed end walls, one at each end of the internal electrode edge, which emerge at the external actuator boundary at the rounded or chamfered corners of the associated one of the sides.

The invention is advantageous in that it lends itself to a particularly accurate and convenient method of construction, as described further below. Further, it lends itself to the insulating region emerging at the associated side of the external electrode boundary at an angle of approximately ninety degrees, rather than there being an acute interface between the recess and the boundary interface.

In a particularly preferred embodiment, therefore, the opposed end walls of the recess emerge at the external actuator boundary at approximately ninety degrees. An angle of substantially ninety degrees is advantageous since it is has been found to reduce stress concentrations within the stack. Ultimately, this reduces the likelihood of cracks occurring and propagating through the actuator.

Each internal electrode element of one polarity is preferably in electrical connection with a first side electrode of like polarity carried by the opposite side of the external electrode boundary to the associated one of the sides adjacent to the recess. The actuator may further comprise a second side electrode of opposite polarity to the first side electrode, which is carried by the associated one of the sides adjacent to the recess so that the insulting region insulates electrically the internal electrode from the second side electrode.

Reference to the external electrode boundary being rectangular is taken to mean either that all sides are of substantially equal length (i.e. square) or that one pair of opposing sides is of one length and the other pair of opposing sides is of a different length.

According to a second aspect of the invention there is provided a fuel injector for use in an internal combustion engine, the fuel injector including a piezoelectric actuator as set out in the first aspect of the invention, for controlling movement of a fuel injector valve needle.

It will be appreciated that preferred and/or optional features of the actuator of the first aspect of the invention may be incorporated within the injector of the second aspect of the invention, alone or in appropriate combination.

According to a third aspect of the invention, there is provided a method of forming a piezoelectric actuator having an external actuator boundary, the method including
providing a stack of piezoelectric elements interleaved with a plurality of internal electrode elements, wherein each of the internal electrode elements is provided with a recess on one side thereof to define an insulating region of the electrode, in use, which is arranged adjacent to a side of the external actuator boundary,
determining a point of emergence of each end of the recess at the side of the external actuator boundary,
determining a position of a vertical central axis of the stack on the basis of the emergence points, and
shaping the external actuator boundary on the basis of the position of the vertical central axis so as to round or chamfer the corners of the external actuator boundary and so as to provide the recess with a substantially uniform width along the side of the external actuator boundary.

The method preferably further includes initially arranging a plurality of piezoelectric element layers interleaved with a plurality of internal electrode element layers to form a primary stack, and cutting the primary stack vertically so as to form a plurality of individual actuator stacks.

### Brief Description of Drawings

Reference has already been made to Figures 1, 2 and 3 of the drawings, which show various known piezoelectric actuators. In order that the invention may be more fully understood, it will now described with reference to the remaining drawings in which;
Figure 4a is a perspective view of a piezoelectric actuator according to the invention, and Figure 4b is a plan view of a lateral slice through the actuator in Figure 4a;
Figure 5 is a plan view of a sheet of piezoelectric layers during a first manufacturing step;
Figure 6 is a plan view of the sheet of piezoelectric layers in Figure 5 during a second manufacturing step;
Figure 7 is a perspective view of a 'rough-cut' piezoelectric actuator prior to a final manufacturing step; and
Figures 8a, 8b and 8c are lateral sectioned views of the actuator shown in Figure 7 during the final manufacturing step.

### Detailed Description of Preferred Embodiments

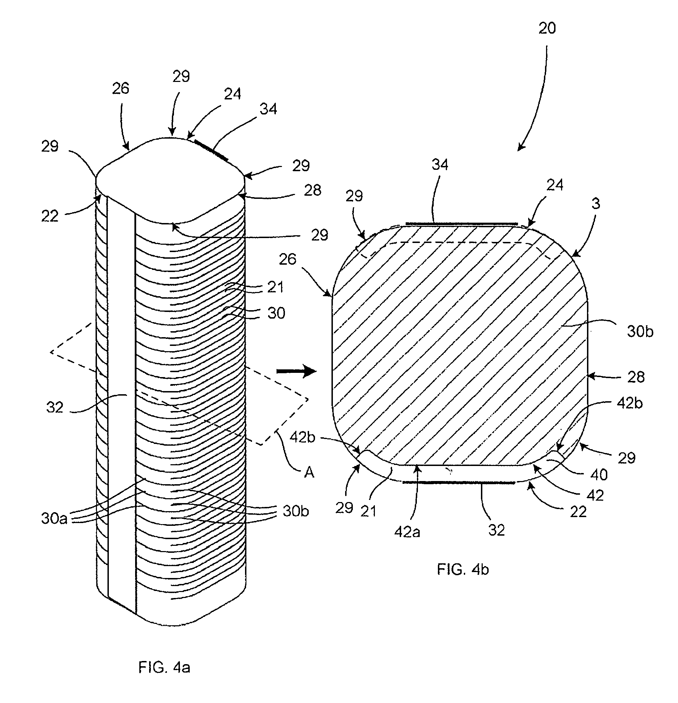

Figures 4a and 4b show a piezoelectric actuator 20 that is particularly suitable for use in a fuel injector of a compression-ignition internal combustion engine. By way of example, our co-pending European patent application EP 1174615 describes a fuel injector in which a piezoelectric actuator controls movement of an injector valve needle to control the injection of fuel into the engine. It should be appreciated, however, that the inventive concept is not limited solely for use with fuel injectors and, instead, the principles described herein are applicable to any stack-type piezoelectric actuator.

The piezoelectric actuator 20 includes a columnar stack of piezoelectric layers, or elements 21 (only two of which are labelled for clarity) having a generally rectangular lateral profile providing the actuator 20 with substantially parallel front and rear faces (or sides) 22, 24 and substantially parallel left and right faces (or sides) 26, 28. It should be understood that the terms 'front', rear', 'left' and 'right' are used here with reference to the actuator 20 as oriented in the drawings but are not to be considered as limiting the actuator to a particular orientation. The corners 29, or vertices, of the actuator faces are radiussed (e.g. rounded) to provide a smooth transition between adjacent faces 22, 24, 26, 28.

Each layer 21 of the actuator 20 is separated by an internal electrode element or layer 30, the outer boundaries of which can be seen emerging around the periphery of the actuator 20. It is worth mentioning at this point that the scale of the actuator 20 in Figures 4a and 4b is greatly exaggerated and, in practice, the actuator 20 would include many more piezoelectric layers 21 and internal electrodes layers 30 than those shown, typically in the order of hundreds.

The internal electrode layers 30 are divided into two groups: a group of positive electrodes 30a (only three of which are identified) and a group of negative electrodes 30b (only three of which are identified). The positive and negative electrode groups 30a, 30b are interdigitated such that the electrodes of the positive group 30a connect with a positive external electrode 32 carried on the front face 22 of the actuator 20 and the electrodes of the negative group 30b connect with a negative external electrode 34 carried on the rear face 24 of the actuator 20.

A plan view of one negative internal electrode layer 30b is shown in Figure 4b which is a lateral slice through the actuator 20 in Figure 4a, along plane A. The internal electrode layer 30b has a boundary that matches the external boundary of the underlying piezoelectric layer 21 except for an elongate insulating region 40 that lays adjacent to the front face 22 of the actuator 20. The insulating region 40 is defined by a recessed region of the electrode layer 30b, which establishes a recessed electrode boundary 42. The recessed boundary 42 has three boundary portions: a central portion 42a that is parallel to the external boundary of the actuator 20, and two end portions 42b that join the central portion 42a to the external boundary of the actuator 20. The central portion 42a of the recessed boundary 42 includes a substantially straight section, which is parallel to the straight section of the actuator face 22, and two curved portions, one at each end of the straight section, which follow the radius of the corners 29 of the actuator face 22.

It is a feature of the invention that the recessed boundary 42 of the electrode 30b extends parallel to the external boundary of the actuator 20 across substantially the entire width of the recess 40, from one end 42b to the other end 42b. The recessed boundary 42 therefore runs parallel to the external boundary of the actuator 20 over both the straight region of the face 22 of the stack and over a portion of the rounded corners 29 on each side of the face 22.

Part way along the rounded corners 29, the recessed boundary 42 diverges from its parallel path and joins to the external boundary of the actuator 20 in order to define the ends 42b, 42b of the insulating region 40. It is a further feature of the invention that the recessed boundary 42 of the electrode 30b is approximately perpendicular to the external boundary of the actuator 20 where the end portions 42b thereof emerge at the surface of the actuator 20. It has been observed that an angle of substantially ninety degrees is most advantageous since it is the most effective angle for reducing stress concentrations within the stack, thus reducing the likelihood of cracks occurring and propagating through the actuator 20.

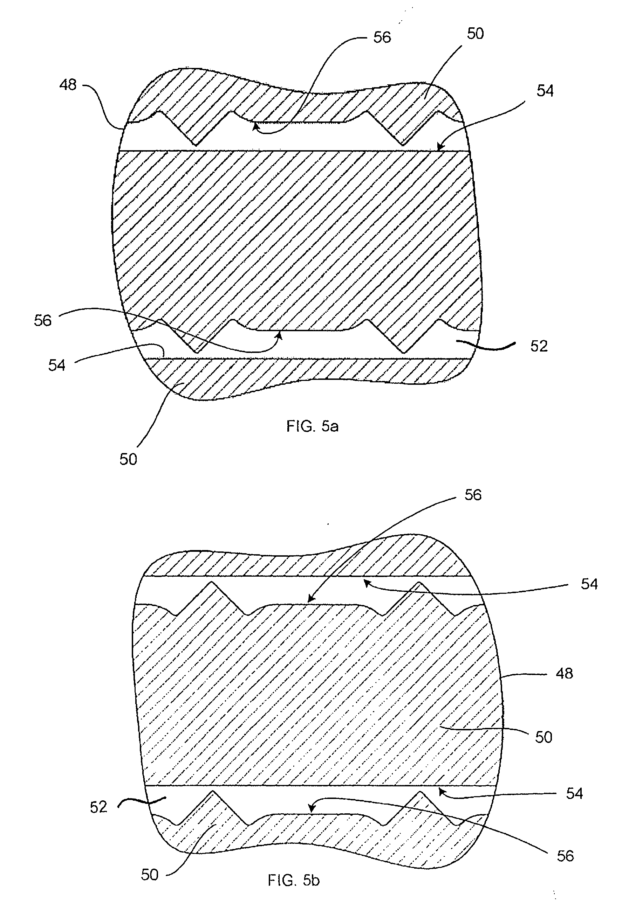

A method of manufacturing the actuator 20 is described below with reference to Figures 5 to 8. By way of background, it is known for individual piezoelectric actuators to be manufactured from a monolithic block. A monolithic block is constructed by alternately layering relatively thin layers of piezoelectric ceramic material and printed patterns of metallised electrode layers. Following the initial layering process the block is relatively fragile. It is known, therefore, to carry out a hardening process in which the block is pressed and co-fired, or sintered, to form a hardened monolithic block on which further manufacturing operations may be applied. An example of a suitable piezoelectric material is lead zirconate titanate (PZT), although it is to be understood that this is not limiting to the inventive concept described here.

Figure 5a shows a plan view of a lateral slice 48 though a monolithic block which is used for the manufacture of the actuator 20 in Figures 4a and 4b. The slice 48 includes an electrode pattern comprising a plurality of metallised strips 50 (only one of which can be seen in full height in Figure 5a) that are disposed in parallel to each other across the surface of an underlying piezoelectric layer 52. The strips 50 are deposited on the upper surface of the layer 52 by a suitable manufacturing process such as screen printing, as is known in the art. Each strip 50 includes a straight upper edge 54 and a non-linear lower edge 56 that is shaped appropriately to provide the finished actuator 20 with the internal electrode shape in Figure 4b.

Figure 5b shows a plan view of a lateral slice through the monolithic block which lays adjacent to (i.e. on top of) the lateral slice in Figure 5a. In successive slices, it can therefore be seen that the electrode patterns are oriented at 180° to one another.

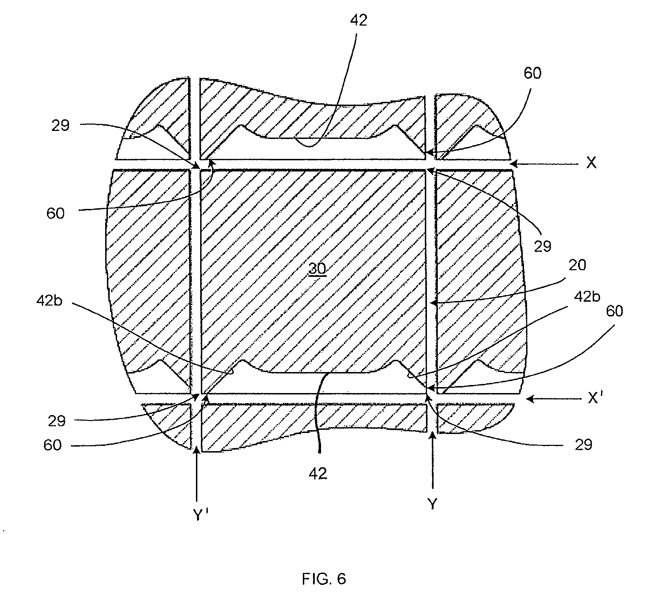

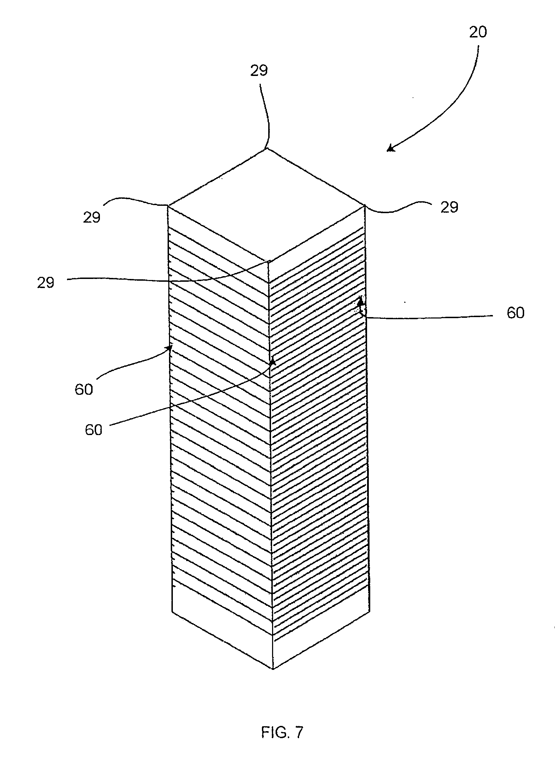

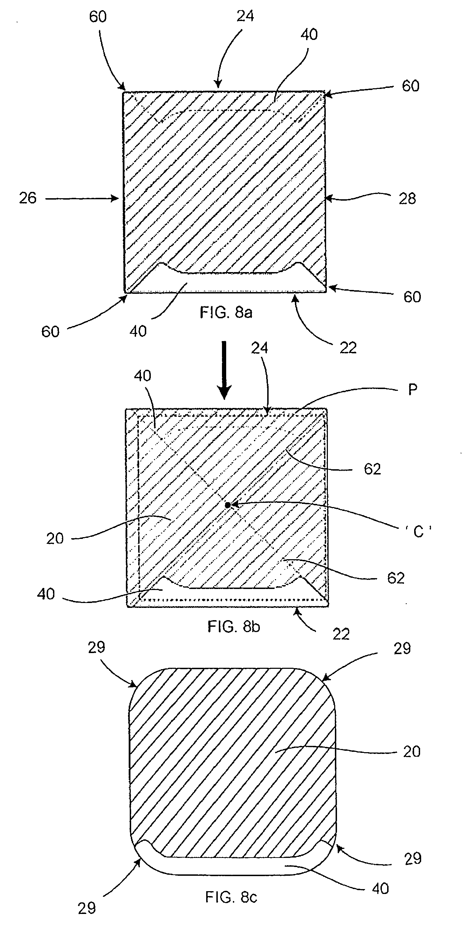

As shown in Figure 6, once the monolithic block has been constructed, it is divided into individual piezoelectric actuator stacks by slicing the block along vertical and horizontal perpendicular planes X, X' and Y, Y' (from the plan view shown). However, the exact position of the internal electrode layers is difficult to predict since the monolithic block distorts during construction by virtue of the pressing and firing operations. As a result, the points at which the end portions 42b of the recessed edge 42 of the internal electrode layers 30 emerge at the external boundary of the actuator 20 (hereinafter referred to as 'emergence points' and indicated generally as 60) may not coincide precisely with the corners 29 of the actuator 20. The resulting 'rough-cut' piezoelectric actuator 20 is shown in Figure 7. In order to machine the actuator 20 into its final form as shown in Figures 4a and 4b, a further manufacturing step is applied as described below with reference to Figures 8a, 8b and 8c.

Figure 8a shows a plan view of a lateral slice through the rough-cut actuator 20 of Figure 7 and illustrates a first part of the final machining process. In this step, the four faces of the actuator 20 (the front face 22, rear face 24, and the left and right side faces 26, 28) are examined by a computer controlled system (not shown) which records the position of each of the emergence points 60. Such computer-controlled apparatus may include a machine vision system which recognises optically the position of the emergence points 60 and records the position with reference to an appropriate coordinate system. A machine vision system for identifying and recording the coordinates of the emergence points 60 is beneficial as physical contact with the actuator 20 is avoided. However, it should be understood that other methods for identifying and recording the position of the emergence points could be used. For example, an electronic probe may be traversed across the external surface of the actuator 20 in order to determine the exact position of the emergence points 60 relative to the actuator edges.

After the emergence points 60 have been identified, recorded and stored, a calculation is performed to find the optimum central axis of the actuator 20. As shown by Figure 8b, two intersecting diagonal lines 62 are created, one between each pair of diagonally opposed emergence points 60. An intersection point 'C' of the lines 62 defines the optimum central axis of the actuator 20. Once the central axis C has been calculated, the system determines an optimum actuator perimeter, as shown by the dashed-box 'P' on Figure 8b, to which the faces 22, 24, 26, 28 of the rough-cut actuator 20 are ground in a machining step. An important factor in calculating the optimum actuator perimeter 'P' is ensuring that the insulating regions 40 on the front and rear faces 22, 24 of the actuator 20 are substantially the same shape and width so as to avoid causing stresses within the actuator 20 during operation. An advantage of this method is that the calculation of the optimum perimeter P permits the size of the insulating regions 40 on each electrode layer 30a, 30b to be tightly controlled. This is an important benefit since the insulating regions 40 require a predetermined width that is calculated to be an acceptable compromise between the requirements of maximizing actuator displacement and sufficiently insulating the internal electrode layers of one polarity from an external electrode of opposite polarity.

The final operation, as shown in Figure 8c, is to machine a radius on each corner 29 of the actuator 20, the radius of the corner 29 being selected as appropriate to be compatible with the environment in which the actuator 20 is to be installed. For example, in EP 1174615 the actuator is installed within a fluid chamber of the injector so the external geometry of the corners 29 would be selected to match the space provided by the fluid chamber.

It will be appreciated that various modifications may be made to the described embodiment without departing from the scope of the invention as defined by the claims. For example, although the above embodiment includes an actuator having a substantially rectangular cross section in which the corners 29 are rounded, it will be appreciated that this is not essential to the invention. An alternative embodiment includes a rectangular-sectioned actuator 20 in which the corner edges 29 are chamfered, or truncated, instead of rounded. This shaping may be preferable for some actuator installations. As described previously, the recessed edge 42 of the internal electrode layer 30b is shaped accordingly to run substantially parallel to the front face 22 of the external stack boundary, from one end 42b of the recess 40 to the other end 42b.

## Claims

1. A piezoelectric actuator (20) comprising:
a stack of piezoelectric elements (21) defining an external actuator boundary of substantially rectangular form and having first and second sides (22, 24, 26, 28) with rounded or chamfered corners (29), and
a plurality of internal electrode elements (30) arranged to form a positive polarity group (30a) of electrode elements and a negative polarity group (30b) of electrode elements, wherein each of the internal electrode elements (30) of one polarity is provided with an insulating region (40) arranged adjacent to an associated one of the first and second sides (22) of the external actuator boundary,
wherein the insulating region (40) is provided by a recess defining an internal electrode edge (42) which is substantially parallel to said associated one of the sides (22) of the external actuator boundary and its corners (29), such that the insulating region (40) has a substantially uniform width along said associated one of the sides (22) of the external actuator boundary, and
**characterised in that** the recess (40, 42) further defines opposed end walls (42b), one at each end of the internal electrode edge (42a), which emerge at the external actuator boundary at the rounded or chamfered corners (29) of the associated one of the sides (22).

2. The piezoelectric actuator of claim 1, wherein the opposed end walls (42b) of the recess (40, 42) emerge at the external actuator boundary at approximately ninety degrees.

3. The piezoelectric actuator of any one of claims 1 and 2, wherein each internal electrode element of one polarity is in electrical connection with a first side electrode (34) of like polarity carried by the opposite side (24) of the external electrode boundary to the associated one of the sides (22) adjacent to the recess (40, 42).

4. The piezoelectric actuator of claim 3, further comprising a second side electrode (32) of opposite polarity to the first side electrode (34), which is carried by the associated one of the sides (22) adjacent to the recess (40, 42) so that the insulting region (40) insulates electrically the internal electrode (30) from the second side electrode (32).

5. The piezoelectric actuator of any one of claims 1 to 4, wherein the external electrode boundary is of substantially square form.

6. A fuel injector for use in an internal combustion engine, the fuel injector including a valve needle which is operable by means of a piezoelectric actuator (20) of any one of claims I to 5.

7. A method of forming a piezoelectric actuator having an external actuator boundary (22, 24, 26, 28), the method including:
providing a stack of piezoelectric elements interleaved with a plurality of internal electrode elements (30), wherein each of the internal electrode elements (30) is provided with a recess (40, 42) on one side thereof to define an insulating region of the electrode, in use, which is arranged adjacent to a side (22) of the external actuator boundary,
and the method further **characterised by**
determining a point of emergence (60) of each end of the recess (40, 42) at said side (22) of the external actuator boundary,
determining a position of a vertical central axis of the stack on the basis of the emergence points (60), and
shaping the external actuator boundary on the basis of the position of the vertical central axis so as to round or chamfer the corners (29) of the external actuator boundary and so as to provide the recess (42) with a substantially uniform width along the side (22) of the external actuator boundary.

8. The method of claim 7, further including:
initially arranging a plurality of piezoelectric element layers interleaved with a plurality of internal electrode element layers to form a primary stack, and
cutting the primary stack vertically so as to form a plurality of individual actuator stacks.

## Patentansprüche

1. Piezoelektrischer Aktor (20), umfassend:
einen Stapel piezoelektrischer Elemente (21), die einen äußeren Aktorrand mit im Wesentlichen rechteckiger Form definieren und erste und zweite Seiten (22, 24, 26, 28) mit abgerundeten oder angefasten Ecken (29) haben, und
mehrere Innenelektrodenelemente (30), die zum Bilden einer Gruppe (30a) von Elektrodenelementen positiver Polarität und einer Gruppe (30b) von Elektrodenelementen negativer Polarität angeordnet sind, wobei jedes der Innenelektrodenelemente (30) einer Polarität mit einem isolierenden Bereich (40) versehen ist, der neben einer assoziierten der ersten und zweiten Seiten (22) des äußeren Aktorrands angeordnet ist,
wobei der isolierende Bereich (40) durch eine Aussparung bereitgestellt wird, die einen Innenelektrodenrand (42) definiert, der im Wesentlichen parallel zu der genannten assoziierten der Seiten (22) des äußeren Aktorrands und ihren Ecken (29) ist, so dass der isolierende Bereich (40) entlang der genannten assoziierten der Seiten (22) des äußeren Aktorrands eine im Wesentlichen einheitliche Breite hat, und
**dadurch gekennzeichnet, dass** die Aussparung (40, 42) ferner einander entgegengesetzte Endwände (42b), je eine an jedem Ende des Innenelektrodenrands (42a), definiert, die an dem Aktoraußenrand an den abgerundeten oder angefasten Ecken (29) der assoziierten der Seiten (22) herausläuft.

2. Piezoelektrischer Aktor nach Anspruch 1, bei dem die einander entgegengesetzten Endwände (42b) der Aussparung (40, 42) an dem Aktoraußenrand im Winkel von etwa neunzig Grad herausläuft.

3. Piezoelektrischer Aktor nach einem der Ansprüche 1 und 2, bei dem jedes Innenelektrodenelement einer Polarität elektrisch mit einer ersten Seitenelektrode (34) der gleichen Polarität verbunden ist, die von der Seite (24) des äußeren Elektrodenrands getragen wird, die der assoziierten der Seiten (22) neben der Aussparung (40, 42) gegenüberliegt.

4. Piezoelektrischer Aktor nach Anspruch 3, ferner umfassend eine zweite Seitenelektrode (34) mit einer der ersten Seitenelektrode (34) entgegengesetzten Polarität, die von der assoziierten der Seiten (22) neben der Aussparung (40, 42) getragen wird, so dass der isolierende Bereich (40) die Innenelektrode (30) elektrisch von der zweiten Seitenelektrode (32) isoliert.

5. Piezoelektrischer Aktor nach einem der Ansprüche 1 bis 4, bei dem der äußere Elektrodenrand im Wesentlichen eine quadratische Form hat.

6. Kraftstoffinjektor zur Verwendung in einer Verbrennungskraftmaschine, wobei der Kraftstoffinjektor eine Ventilnadel aufweist, die mithilfe eines piezoelektrischen Aktors (20) nach einem der Ansprüche 1 bis 5 betätigt werden kann.

7. Verfahren zum Herstellen eines piezoelektrischen Aktors mit einem Aktoraußenrand (22, 24, 26, 28), wobei das Verfahren Folgendes aufweist:
Bereitstellen eines Stapels von piezoelektrischen Elementen, zwischen denen mehrere Innenelektrodenelemente (30) angeordnet sind, wobei jedes der Innenelektrodenelemente (30) an einer Seite von ihm mit einer Aussparung (40, 42) versehen ist, um im Gebrauch einen isolierenden Bereich der Elektrode zu definieren, der neben einer Seite (22) des Aktoraußenrands angeordnet ist,
und wobei das Verfahren ferner **gekennzeichnet ist durch**
das Ermitteln eines Auslaufpunktes (60) jedes Endes der Aussparung (40, 42) an der genannten Seite (22) des Aktoraußenrands,
das Ermitteln einer Position einer vertikalen Mittelachse des Stapels auf der Basis der Auslaufpunkte (60) und
Gestalten des Aktoraußenrands auf der Basis der Position der vertikalen Mittelachse, um die Ecken (29) des Aktoraußenrands abzurunden oder mit einer Fase zu versehen und um die Aussparung (42) mit einer entlang der Seite (22) des Aktoraußenrands im Wesentlichen einheitlichen Breite zu versehen.

8. Verfahren nach Anspruch 7, das ferner Folgendes aufweist:
anfängliches Anordnen von mehreren Lagen piezoelektrischer Elemente, zwischen denen mehrere Innenelektrodenelementlagen angeordnet sind, zu einem Hauptstapel und
vertikales Schneiden des Hauptstapels, um mehrere einzelne Aktorstapel zu bilden.

## Revendications

1. Actionneur piézo-électrique (20), comprenant :
un empilement d'éléments piézo-électriques (21) définissant une frontière d'actionneur externe de forme sensiblement rectangulaire et ayant un premier et un second côté (22, 24, 26, 28) avec des coins arrondis ou chanfreinés (29), et
une pluralité d'éléments d'électrode internes (30) agencés pour former un groupe à polarité positive (30a) d'éléments d'électrode, et un groupe à polarité négative (30b) d'éléments d'électrode, dans lesquels chacun des éléments d'électrode interne (30) d'une polarité est doté d'une région isolante (40) agencée adjacente à un côté associé parmi le premier et le second côté (22) de la frontière d'actionneur externe,
dans lequel la région isolante (40) est constituée par un évidement définissant un bord d'électrode interne (42) qui est sensiblement parallèle audit côté associé parmi les côtés (22) de la frontière d'actionneur externe et ses coins (29), de sorte que la région isolante (40) a une largeur sensiblement uniforme le long dudit côté associé parmi les côtés (22) de la frontière d'actionneur externe, et
**caractérisé en ce que** l'évidement (40, 42) définit en outre des parois terminales opposées (42b), une à chaque extrémité de la bordure d'électrode interne (42a), qui émergent au niveau de la frontière d'actionneur externe aux coins arrondis ou chanfreinés (29) du côté associé (22).

2. Actionneur piézo-électrique selon la revendication 1, dans lequel les parois terminales opposées (42b) des évidements (40, 42) émergent au niveau de la frontière d'actionneur externe sous approximativement 90°.

3. Actionneur piézo-électrique selon l'une quelconque des revendications 1 et 2, dans lequel chaque élément d'électrode interne d'une polarité est en connexion électrique avec une première électrode latérale (34) de même polarité portée par le côté opposé (24) de la frontière d'électrode externe vers le côté associé (22) adjacent à l'évidement (40, 42).

4. Actionneur piézo-électrique selon la revendication 3, comprenant en outre une seconde électrode latérale (32) de polarité opposée à la première électrode latérale (34), qui est portée par le côté associé (22) adjacent à l'évidement (40, 42) de sorte que la région isolante (40) isole électriquement l'électrode interne (30) vis-à-vis de la seconde électrode latérale (32).

5. Actionneur piézo-électrique selon l'une quelconque des revendications 1 à 4, dans lequel la frontière d'électrode externe a sensiblement une forme carrée.

6. Injecteur de carburant destiné à être utilisé dans un moteur à combustion interne, l'injecteur de carburant incluant une aiguille de valve qui est capable de fonctionner au moyen d'un actionneur piézo-électrique (20) selon l'une quelconque des revendications 1 à 5.

7. Procédé pour former un actionneur piézo-électrique ayant une frontière d'actionneur externe (22, 24, 26,28), le procédé incluant les étapes suivantes :
fourniture d'un empilement d'éléments piézo-électriques intercalés avec une pluralité d'éléments d'électrodes internes (30), chacun des éléments d'électrodes internes (30) étant pourvue d'un évidement (40, 42) sur un côté pour définir une région isolante de l'électrode, en utilisation, qui est agencée adjacente à un côté (22) de la frontière d'actionneur externe,
le procédé étant en outre **caractérisé en ce que**
on détermine un point d'émergence (60) de chaque extrémité de l'évidement (40, 42) sur ledit côté (22) de la frontière d'actionneur externe,
on détermine une position d'un axe central vertical de l'empilement en se basant sur les points d'émergence (60), et on conforme la frontière d'actionneur externe en se basant sur la position de l'axe central vertical de manière à arrondir ou à chanfreiner les coins (29) de la frontière d'actionneur externe et de façon à conférer à l'évidement (42) une largeur sensiblement uniforme le long du côté (22) de la frontière d'actionneur externe.

8. Procédé selon la revendication 7, incluant en outre les étapes suivantes :
on agence initialement une pluralité de couche d'éléments piézo-électriques intercalées avec une pluralité de couches d'éléments d'électrodes internes pour former un empilement primaire, et
on coupe l'empilement primaire verticalement de façon à former une pluralité d'empilements d'actionneurs individuels.
